Europäisches Patentamt

European Patent Office

Office européen des brevets

(11) Publication number: **0 666 649 A2**

## EUROPEAN PATENT APPLICATION

(21) Application number: **95101705.2**

(22) Date of filing: **08.02.95**

(51) Int. Cl.⁶: **H03K 19/0185**, H03K 19/003, H03K 17/30

(30) Priority: **08.02.94 JP 14257/94**

(43) Date of publication of application:
**09.08.95 Bulletin 95/32**

(84) Designated Contracting States:
**DE FR GB**

(71) Applicant: **KABUSHIKI KAISHA TOSHIBA**
**72, Horikawa-cho,**
**Saiwai-ku**
**Kawasaki-shi,**
**Kanagawa-ken 210,**
**Tokyo (JP)**

(72) Inventor: **Kinugasa, Masanori, c/o Intellectual**
**Property Div.**

**Kabushiki Kaisha Toshiba,**
**1-1 Shibaura 1-chome**
**Minato-ku,**
**Tokyo 105 (JP)**
Inventor: **Shigehara, Hiroshi, c/o Intellectual**
**Property Div.**
**Kabushiki Kaisha Toshiba,**
**1-1 Shibaura 1-chome**
**Minato-ku,**
**Tokyo 105 (JP)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **Input circuit.**

(57) An input signal (VIN) is input to a gate of a first PMOS transistor (P1) and a gate of a first NMOS transistor (N1). A source of a second PMOS transistor (P2) is connected to a drain of the first PMOS transistor (P1). A source of a second NMOS transistor (N2) is connected to a drain of the first NMOS transistor (N1). An output signal (VOUT) is output through drains of the second PMOS transistor (P2) and the second NMOS transistor (N2). A source of the first PMOS transistor (P1) and a gate of the second NMOS transistor (N2) are connected to a first parasitic unit (LC1). A source of the first NMOS transistor (N1) and a gate of the second PMOS transistor (P2) are connected to a second parasitic unit (LC2).

F I G. 7

The present invention relates to an input circuit of a semiconductor integrated circuit, which receives an input signal whose potential varies gradually.

FIG. 1 shows a conventional input circuit. This input circuit comprises a CMOS inverter including a P channel type MOS transistor P1 and an N channel type MOS transistor N1.

FIG. 2 shows an inverter circuit of three stages, including the input circuit shown in FIG. 1 in the first stage. Drawbacks of the conventional input circuit will be described, using the inverter circuit I1 to I3.

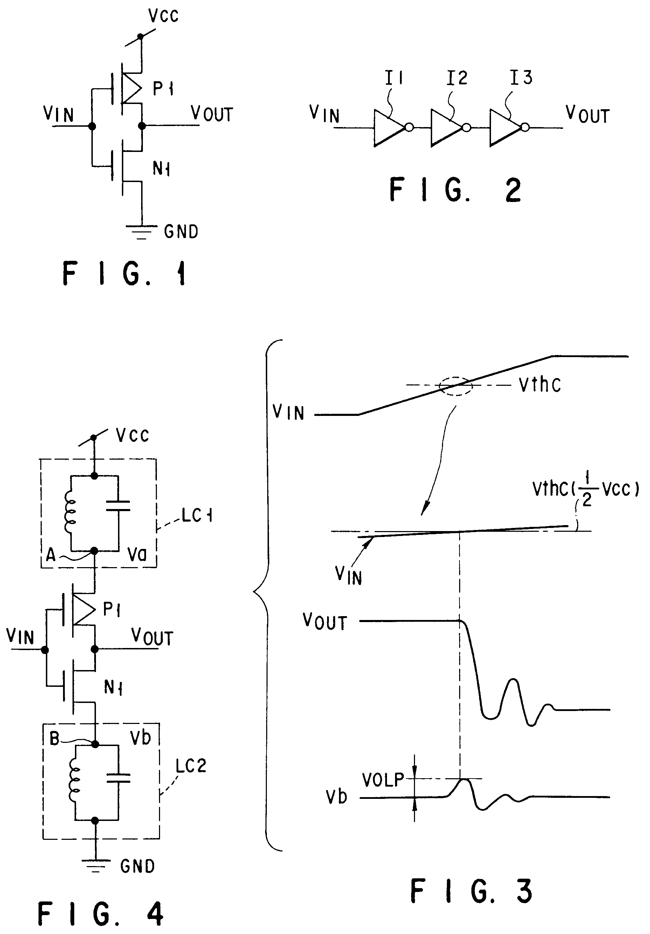

Assume that an input signal VIN, which gradually varies from a low level to a high level as shown in FIG. 3, is input to the inverter circuit shown in FIG. 2. In this case, when the input signal VIN exceeds a threshold value of the inverter circuit (input circuit) I1, an output signal VOUT is changed from a high level to a low level at the same time. This change of the output signal VOUT induces noise in a ground potential GND, which causes so-called ground distortion in the ground potential GND.

An influence of the ground distortion on the threshold value of the inverter circuit (input circuit) I1 will now be described.

First, an amount of the change of the threshold value of an input circuit shown in FIG. 4 is calculated. It is assumed that the input circuit is incorporated in an IC chip. Reference numerals LC1 and LC2 respectively denote a parasitic capacitance and a parasitic reactance formed of a lead frame and a bonding wire.

In a case where a constant in connection with the P channel MOS transistor P1 is $\beta$P, a threshold value of the P channel MOS transistor P1 is $|VthP|$, a constant in connection with the N channel MOS transistor N1 is $\beta$N and a threshold value of the N channel MOS transistor N1 is VthN, the following equation (1) is obtained:

$$-\frac{1}{2}\beta P \ (VCC-VIN-|VthP|)^2 \ = \ -\frac{1}{2}\beta N \ (VIN-VthN)^2$$

$$VCC-VIN-|VthP| \ = \ \sqrt{\frac{\beta N}{\beta P}} \ (VIN-VthN)$$

$$VIN \ = \ \frac{VCC-|VthP|+\sqrt{\frac{\beta N}{\beta P}} \ VthN}{1+\sqrt{\frac{\beta N}{\beta P}}} \qquad \cdots \ (1)$$

When ground distortion occurs in the ground potential GND and a potential Vb at a node B becomes VOLP, the following equation (2) is obtained. VOLP represents a maximum value of the height of a wave of the ground distortion.

$$-\frac{1}{2}\beta P \ (VCC-VIN-|VthP|)^2 \ = \ -\frac{1}{2}\beta N \ (VIN-VOLP-VthN)^2$$

$$VIN \ = \ \frac{VCC-|VthP|+\sqrt{\frac{\beta N}{\beta P}} \ (VOLP+VthN)}{1+\sqrt{\frac{\beta N}{\beta P}}} \qquad \cdots \ (2)$$

An amount $\Delta$Vth (= equation (2) - equation (1)) of change of the threshold value of the input circuit due to the ground distortion is obtained by the following equation (3):

$$\Delta Vth \ = \ \frac{\sqrt{\frac{\beta N}{\beta P}} \ VOLP}{1 \ +\sqrt{\frac{\beta N}{\beta P}}} \qquad \cdots \ (3)$$

In the equation (3), if $\beta$P is equal to $\beta$N, the following relationship is achieved:

$$\Delta Vth \ = \ VOLP/2$$

As described above, when ground distortion occurs, if the conventional input circuit is designed such that the driving force of the P channel MOS transistor P1 is equal to that of the N channel MOS transistor N1 ($\beta$P = $\beta$N), the threshold value of the input circuit is increased by VOLP/2 from an ordinary threshold value Vthc.

The increase of the threshold value of the input circuit results in that the level of the input signal VIN is regarded as lower than the threshold value of the input circuit, if the input signal VIN varies very little (gradually). Therefore, even if the input signal VIN is greater than Vthc but approximate to Vthc, the input signal VIN can be regarded as low in level. In this case, the output signal VOUT is changed from the low level to the high level.

When the ground distortion is eliminated, the threshold value of the input circuit is returned to the normal value Vthc. At this time, the input signal VIN becomes high in level again and the output signal VOUT is changed from the high level to the low level.

In short, the level of the output signal may be changed, every time the ground distortion occurs.

Therefore, for example, a three-stage inverter circuit using the conventional input circuit is disadvantageous in that the output signal VOUT is changed from the high level to the low level, and from the low level to the high level, while the input signal VIN is changed from the low level to the high level, resulting in a malfunction of another element which receives the output signal VOUT.

If the maximum value of the height of a wave of ground distortion is much smaller than the source voltage (e.g., if VOLP is smaller than 1V and the source voltage is 5V), the output signal VOUT does not oscillate. In contrast, if the maximum value of the wave height of ground distortion is not very smaller than the source voltage (e.g., if VOLP is 1V or greater and the source voltage is 5V), the output signal VOUT probably oscillates.

Also in a case where the input signal VIN is changed from the high level to the low level, with the result that noise is induced in a source potential VCC and source distortion occurs in the power source, the output signal VOUT is oscillated in the same manner as in the case where ground distortion occurs.

As described above, according to the conventional art, if the input signal varies gradually, the threshold value of an input circuit is increased or decreased and the level of the input signal is regarded as lower or higher than a normal level, resulting in oscillation of the output signal.

The present invention has been made to overcome the above drawbacks of the conventional art, and its object is to provide a simple input circuit wherein, when distortion in a ground potential or source potential occurs due to a gradual change of an input signal, the degree of change in the threshold value of the input circuit is lowered, thereby preventing oscillation of an output signal.

According to an aspect of the present invention, to achieve the above object, there is provided an input circuit comprising: a first MOS transistor of a first conductivity type having a source connected to a first potential supplying source and a gate to which an input signal is input; a second MOS transistor of a second conductivity type having a source connected to a second potential supplying source and a gate to which the input signal is input; a third MOS transistor of the first conductivity type having a source connected to a drain of the first MOS transistor, a gate connected to the second potential supplying source and a drain through which an output signal is output; and a fourth MOS transistor of the second conductivity type having a source connected to a drain of the second MOS transistor, a gate connected to the first potential supplying source and a drain through which the output signal is output.

The source of the first MOS transistor and the gate of the fourth MOS transistor are connected to the first potential supplying source via a first parasitic capacitance and parasitic reactance; and the source of the second MOS transistor and the gate of the third MOS transistor are connected in common to the second potential supplying source via a second parasitic capacitance and parasitic reactance.

According to another aspect of the present invention, there is provided an input circuit comprising: a first MOS transistor of a first conductivity type having a source connected to a first potential supplying source and a gate to which an input signal is input; a second MOS transistor of a second conductivity type having a source connected to a second potential supplying source, a gate to which the input signal is input and a drain through which an output signal is output; a third MOS transistor of the first conductivity type having a source connected to a drain of the first MOS transistor, a gate connected to the second potential supplying source and a drain through which the output signal is output.

The source of the second MOS transistor and the gate of the third MOS transistor are connected in common to the second potential supplying source via a parasitic capacitance and parasitic reactance.

According to still another aspect of the present invention, there is provided an input circuit comprising: a first MOS transistor of a first conductivity type having a source connected to a first potential supplying source, a gate to which an input signal is input and a drain through which an output signal is output; a

3

second MOS transistor of a second conductivity type having a source connected to a second potential supplying source and a gate to which the input signal is input; and a third MOS transistor of the second conductivity type having a source connected to a drain of the second MOS transistor, a gate connected to the first potential supplying source and a drain through which the output signal is output.

The source of the first MOS transistor and the gate of the third MOS transistor are connected to the first potential supplying source via a capacitance and parasitic reactance.

With the above structure, even when the potential supplied from the first or second potential supplying source is distorted, so that the driving force of the first or second MOS transistors is reduced, the driving force of the third or fourth MOS transistor can also be reduced, thereby suppressing change in the threshold value of the input circuit.

The threshold of the input circuit is thus prevented from changing, even if the potential supplied from the first or second potential supplying source is distorted. Therefore, when the input signal varies gradually around the threshold value of the input circuit, an output signal is prevented from oscillating.

This invention can be more fully understood from the following detailed description when taken in conjunction with the accompanying drawings, in which:

FIG. 1 is a circuit diagram showing a conventional input circuit;

FIG. 2 is a three-stage inverter circuit using the input circuit shown in FIG. 1;

FIG. 3 is a waveform diagram showing an operation of the inverter circuit shown in FIG. 2;

FIG. 4 is a circuit diagram showing details of the input circuit shown in FIG. 1;

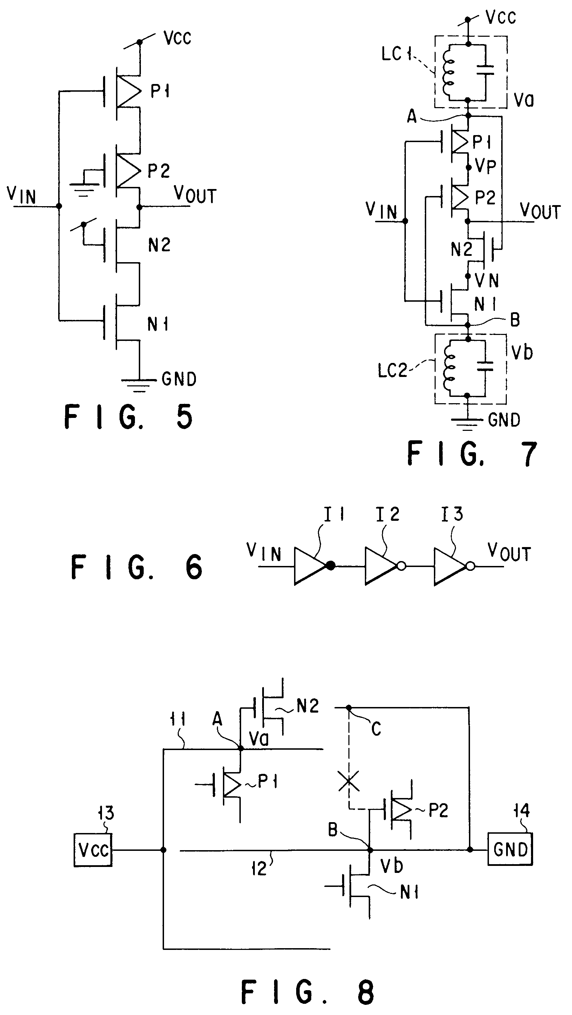

FIG. 5 is a circuit diagram showing an input circuit according to a first embodiment of the present invention;

FIG. 6 is a three-stage inverter circuit using the input circuit shown in FIG. 5;

FIG. 7 is a circuit diagram showing details of the input circuit shown in FIG. 5;

FIG. 8 is a diagram showing a wiring pattern of the input circuit shown in FIG. 5;

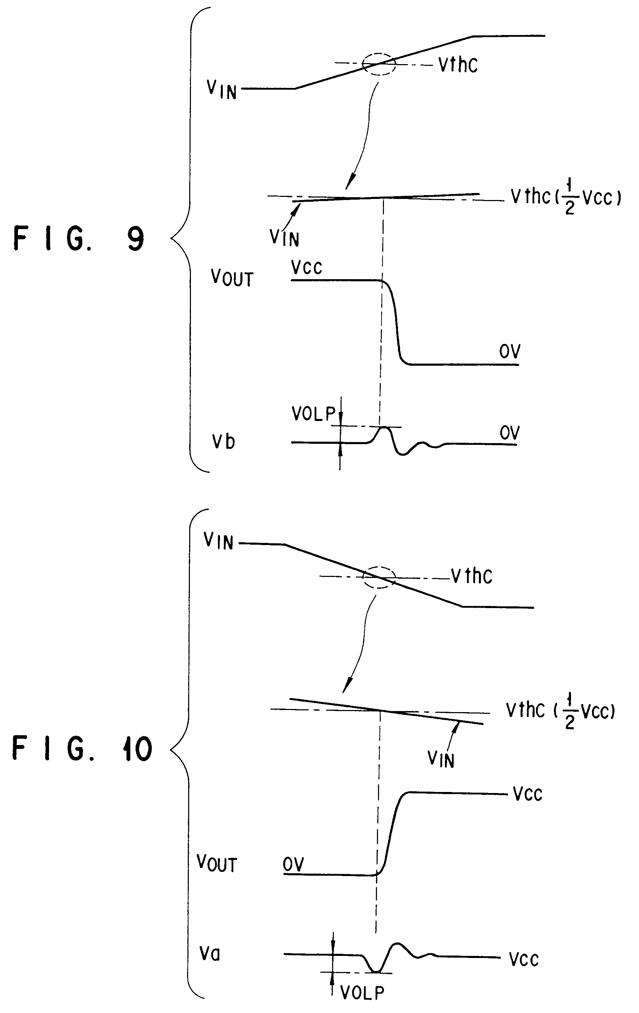

FIG. 9 is a waveform diagram showing an operation of the inverter circuit shown in FIG. 7;

FIG. 10 is a waveform diagram showing an operation of the inverter circuit shown in FIG. 7;

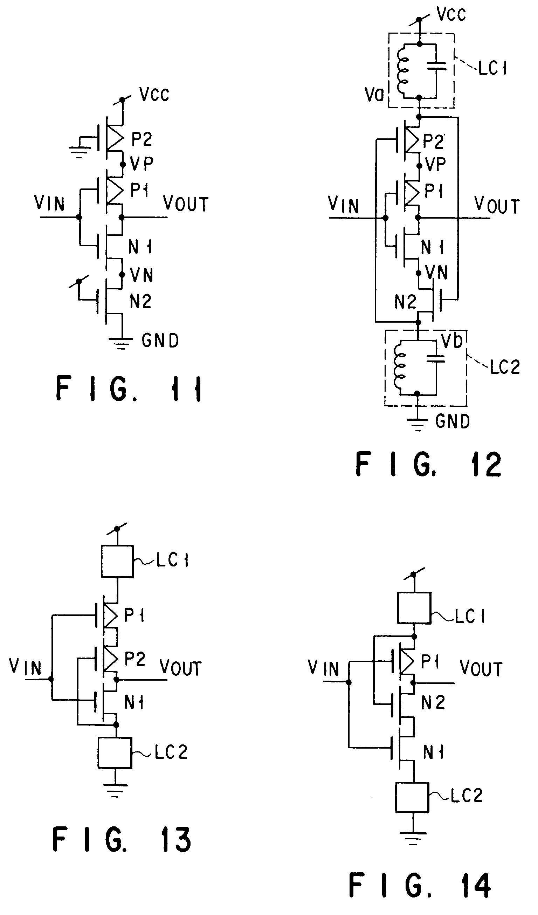

FIG. 11 is a circuit diagram showing an input circuit according to a second embodiment of the present invention;

FIG. 12 is a circuit diagram showing details of the input circuit shown in FIG. 11;

FIG. 13 is a circuit diagram showing an input circuit according to a third embodiment of the present invention; and

FIG. 14 is a circuit diagram showing an input circuit according to a fourth embodiment of the present invention.

Embodiments of the present invention will be described in detail with reference to the accompanying drawings.

FIG. 5 shows an input circuit according to a first embodiment of the present invention.

The input circuit comprises a CMOS inverter including P channel type MOS transistors (PMOS transistors) P1 and P2 and N channel type MOS transistors (NMOS transistors) N1 and N2.

The PMOS transistor P1 has a source to which a source potential (high potential) VCC is applied and a gate to which an input signal VIN is input. The NMOS transistor N1 has a source to which a ground potential (low potential) GND is applied and a gate to which the input signal VIN is input.

The PMOS transistor P2 has a source connected to a drain of the PMOS transistor P1, a gate to which the ground potential GND is applied, and a drain through which an output signal VOUT is output. The NMOS transistor N2 has a source connected to a drain of the NMOS transistor N1, a gate to which the source potential VCC is applied, and a drain through which the output signal VOUT is output.

The input signal VIN gradually changes from a low level to a high level, and from a high level to a low level.

FIG. 6 shows a three-stage inverter circuit using the input circuit shown in FIG. 5 as a first stage. Described below is a case in which an input signal VIN, gradually changing from a low level to a high level, is input to the inverter circuit shown in FIG. 6.

In this case, if the input signal VIN exceeds a threshold value of the inverter circuit (input circuit) I1, the output signal VOUT is inverted from a high level to a low level. The change in the output signal VOUT induces noise in the ground potential GND, causing ground distortion in the ground potential GND.

An influence of the ground distortion on the threshold value of the inverter circuit (input circuit) I1 of this embodiment will be described below.

FIG. 7 illustrates details of the input circuit shown in FIG. 5.

It is assumed that the input circuit is incorporated in an IC chip. Reference numerals LC1 and LC2 respectively denote a parasitic capacitance and a parasitic reactance (hereinafter referred to as a parasitic

4

unit) formed of a lead frame and a bonding wire.

The source of the PMOS transistor P1 and the gate of the NMOS transistor N2 are connected in common to a power source through the parasitic unit (parasitic capacitance and parasitic reactance) LC1. The source of the NMOS transistor N1 and the gate of the PMOS transistor P2 are connected in common to the ground through the parasitic unit (parasitic capacitance and parasitic reactance) LC2.

FIG. 8 is a schematic diagram showing a pattern of the input circuit shown in FIG. 7.

A power source line 11, extending from a power source pad 13, is arranged in the input circuit. The source of the PMOS transistor P1 and the gate of the NMOS transistor N2 are connected to a node A of the power source line 11. As a result, the source of the PMOS transistor P1 and the gate of the NMOS transistor N2 are connected in common to the power source through the parasitic unit LC1.

A grounded line 12, extending from a grounded pad 14, is arranged in the input circuit. The source of the NMOS transistor N1 and the gate of the PMOS transistor P2 are connected to a node B of the grounded line 12. As a result, the source of the NMOS transistor N1 and the gate of the PMOS transistor P2 are connected in common to the power source through the parasitic unit LC2.

Note that if the source of the NMOS transistor N1 is connected to the node B, the gate of the PMOS transistor P2 must be connected to the node B, not to, for example, a node C of the grounded line 12, for the following reason.

For example, when a potential Vb at the node B is distorted (increased) due to a current flowing through the grounded pad, a potential of VOLP is supplied to the source of the NMOS transistor N1, which is normally set to the ground potential. As a result, the gate-source potential of the NMOS transistor N1 is lowered, thereby decreasing the driving force of the NMOS transistor N1. Hence, the gate of the PMOS transistor P2 is connected to the node B to supply the potential Vb to the gate, so that the gate-source potential of the PMOS transistor P2 can also be lowered. As a result, the change in the threshold value of the input circuit is suppressed.

An amount of the change in the threshold value of the input circuit shown in FIG. 7 will be described below.

Assume that a constant in connection with the PMOS transistors P1 and P2 is $\beta$P, a threshold value of the PMOS transistor P1 is |VthP|, a constant in connection with the NMOS transistors N1 and N2 is $\beta$N and a threshold value of the N channel MOS transistor N1 is VthN.

TABLE 1

|     | VGS-Vth        | VDS                  |
| --- | -------------- | -------------------- |
| P1  | VCC-VIN-IVthPI | VCC-VP               |
| P2  | VP-VOLP-IVthPI | VP-$\frac{1}{2}$ VCC |
| N1  | VIN-VOLP-VthN  | VN-VOLP              |
| N2  | VCC-VN-VthN    | $\frac{1}{2}$ VCC-VN |

First, described is a case in which an input signal is changed from a low level to a high level as shown in FIG. 9.

In this case, as is evident from TABLE 1, the formula for obtaining a threshold value of the input circuit varies depending on which of the PMOS transistors P1 and P2 determines the amount of a current or which of the NMOS transistors N1 and N2 determines the amount of a current.

In this embodiment, since the PMOS transistors P1 and P2 have the same constant $\beta$P, the amount of a current flowing through the PMOS transistors is determined by the PMOS transistor P2, to which a smaller gate bias is applied. Similarly, since the NMOS transistors N1 and N2 have the same constant $\beta$N, the amount of a current flowing through the NMOS transistors is determined by the NMOS transistor N1, to which a smaller gate bias is applied.

Assuming that ground distortion occurs in the ground potential GND and the potential Vb at the node B becomes VOLP, the threshold value of the input circuit is obtained in the following manner.

(1) When the potential Vb at the node B is increased to VOLP, the driving force of the NMOS transistor N1 is lowered. Since the PMOS transistor P2 determines the amount of the current, the driving force of the PMOS transistor P2 is lowered. As a result, the change in the threshold value of the input circuit is suppressed.

5

The PMOS transistor P2 determines the amount of the current, only when it is saturated. To saturate the PMOS transistor P2, it is only necessary that the relation VGS-Vth < VDS be satisfied in the PMOS transistor P2.

Hence, the following formula (4) is obtained on the basis of TABLE 1:

$$VP\text{-}VOLP\text{-}|VthP| < VP\text{-}VCC/2 \quad VOLP > VCC/2\text{-}|VthP| \tag{4}$$

To saturate the NMOS transistor N1, it is only necessary that the relation VGS-Vth < VDS be satisfied in the NMOS transistor N1.

Hence, the following formula (5) is obtained on the basis of TABLE 1:

$$VIN\text{-}VOLP\text{-}VthP < VN\text{-}VOLP \quad VIN\text{-}VthN < VN \tag{5}$$

Since the PMOS transistor P2 and the NMOS transistor N1 are saturated if both the formulas (4) and (5) are satisfied, the threshold value of the input circuit is expressed by the following equation (6):

$$-\frac{1}{2}\beta P\ (VP\text{-}VOLP\text{-}|VthP|)^2 = -\frac{1}{2}\beta N\ (VIN\text{-}VOLP\text{-}VthN)^2$$

$$\sqrt{\frac{\beta P}{\beta N}}\ (VP\text{-}VOLP\text{-}|VthP|) = VIN\text{-}VOLP\text{-}VthN$$

$$VIN = VOLP\text{+}VthN\text{+}\sqrt{\frac{\beta P}{\beta N}}\ (VP\text{-}VOLP\text{-}|VthP|)$$

$$\ldots (6)$$

If $\beta P = \beta N$, the equation (6) can be simplified as follows:

$$VIN = VP + VthN\text{-}|VthP| \tag{7}$$

As clear from the equation (7), the threshold value of the input circuit is constant, irrespective of the value of VOLP, i.e., the maximum value of the wave height of ground distortion.

The above effect, however, is obtained only when the following condition of the maximum value VOLP of the wave height of the ground distortion is satisfied:

$$VOLP > (VCC/2)\text{-}VthN.$$

In other words, the present invention is effective, only when the maximum value VOLP is relatively great and close to the source voltage.

However, when the maximum value VOLP is relatively small (i.e., the above condition is not satisfied), the output signal VOUT does not oscillate, even if the ground distortion occurs. The above condition, therefore, is not indispensable to the present invention.

An operation of the PMOS transistor P2 will be described.

If the PMOS transistor P2 is unsaturated and the PMOS transistor P1 is saturated, the threshold value of the input circuit is increased by ΔVth (=VOLP/2) from the normal threshold value Vthc due to the ground distortion in the same manner as in the conventional input circuit.

If both the PMOS transistors P1 and P2 are saturated, even if the condition VOLP > (VCC/2)-VthN is not satisfied, the gate bias of the PMOS transistor is increased, thereby reducing the driving force of the PMOS transistor P2. As a result, the reduction in driving force of the NMOS transistor N1 can be compensated, so that the change in the threshold value of the input circuit can be suppressed.

As described above, if both the PMOS transistor P2 and the NMOS transistor N1 are saturated, the output signal can be prevented from oscillating, irrespective of the driving force of the PMOS transistors P1 and P2.

(2) In a case where the input signal changes from the high level to the low level as shown in FIG. 10, if source distortion occurs in the source potential VCC and the potential Va at the node A becomes VCC-VOLP, the threshold value of the input circuit is obtained as follows, assuming that Va = VCC-VOLP and Vb = 0.

TABLE 2

| | | VGS-Vth | VDS |
|---|---|---|---|
| | P1 | VCC-VOLP-VIN-IVthPI | VCC-VOLP-VP |
| | P2 | VP-IVthPI | VP-$\frac{1}{2}$ VCC |
| | N1 | VIN-VthN | VN |
| | N2 | VCC-VOLP-VN-VthN | $\frac{1}{2}$ VCC-VN |

If the potential Va at the node A is reduced by VOLP from VCC, the driving force of the PMOS transistor P1 is reduced. Hence, the NMOS transistor N2 is constructed so as to determine the amount of a current and the driving force of the NMOS transistor N2 is reduced. As a result, the change in the threshold value of the input circuit is suppressed.

The NMOS transistor N2 determines the amount of the current, only when it is saturated. To saturate the NMOS transistor N2, it is only necessary that the relation VGS-Vth < VDS be satisfied in the NMOS transistor N2.

Hence, the following formula (8) is obtained on the basis of TABLE 2:

$$VCC-VOLP-VN-VthN < (VCC/2)-VN \quad VOLP > VCC/2-VthN \qquad (8)$$

To saturate the PMOS transistor P1, it is only necessary that the relation VGS-Vth < VDS be satisfied in the PMOS transistor P1.

Hence, the following formula (9) is obtained on the basis of TABLE 2:

$$VCC-VOLP-VIN-|VthP| < VCC-VOLP-VP \quad VIN+|VthP| > VP \qquad (9)$$

Since the NMOS transistor N2 and the PMOS transistor P1 are saturated if both the formulas (8) and (9) are satisfied, the threshold value of the input circuit is expressed by the following equation (10):

$$\frac{1}{2}\beta P \; (VCC-VOLP-VIN-|VthP|)^2$$
$$= \frac{1}{2}\beta N \; (VCC-VOLP-VN-VthN)^2$$

$$\sqrt{\frac{\beta P}{\beta N}} \; (VCC-VOLP-VIN-|VthP|) = VCC-VOLP-VN-VthN$$

$$VIN = VCC-VOLP-|VthP|-\sqrt{\frac{\beta N}{\beta P}} \; (VCC-VOLP-VN-VthN)$$
$$\cdots \; (10)$$

If $\beta P = \beta N$, the equation (10) can be simplified as follows:

$$VIN = VN+VthN-|VthP| \qquad (11)$$

As clear from the equation (11), the threshold value of the input circuit is constant, irrespective of the value of VOLP, i.e., the maximum value of the wave height of source distortion.

The above effect, however, is obtained only when the following condition of the maximum value VOLP of the wave height of the source distortion is satisfied:

$$VCC-VOLP < (VCC/2)+|VthP| \quad VOLP > (VCC/2)-|VthN|$$

In other words, the present invention is effective, only when the maximum value VOLP is relatively great and close to the source voltage.

However, when the maximum value VOLP is relatively small (i.e., the above condition is not satisfied), the output signal VOUT does not oscillate, even if the source distortion occurs. The above condition, therefore, is not indispensable to the present invention.

FIGS. 11 and 12 show an input circuit according to a second embodiment of the present invention.

The input circuit comprises a CMOS inverter including PMOS transistors P1 and P2 and NMOS transistors N1 and N2.

The PMOS transistor P1 has a gate to which an input signal VIN is input and a drain through which an output signal VOUT is output. The NMOS transistor N1 has a gate to which the input signal VIN is input and a drain through which the output signal VOUT is output.

The PMOS transistor P2 has a source to which a source potential (high potential) VCC is applied, a gate to which a ground potential (low potential) GND is applied, and a drain connected to a source of the PMOS transistor P1. The NMOS transistor N2 has a source to which the ground potential (low potential) GND is applied, a gate to which the source potential (high potential) VCC is applied, and a drain connected to a source of the NMOS transistor N1.

The source of the PMOS transistor P1 and the gate of the NMOS transistor N2 are connected in common to a power source via a parasitic unit (parasitic capacitance and parasitic reactance formed of a wire, a lead frame and a bonding wire) LC1. The source of the NMOS transistor N1 and the gate of the PMOS transistor P2 are connected in common to the power source (the ground) via a parasitic unit LC2.

The input signal VIN gradually changes from a low level to a high level, and from a high level to a low level.

The input circuit of this embodiment differs from the input circuit of the first embodiment only in that the PMOS transistor P2 is connected between the power source and the PMOS transistor P1 and the NMOS transistor N2 is connected between the ground and the NMOS transistor N1. The other portions of the second embodiment are the same as those in the first embodiment.

The input circuit of the second embodiment can provide the same effect as in the first embodiment.

FIG. 13 shows an input circuit according to a third embodiment of the present invention.

The input circuit comprises a CMOS inverter including PMOS transistors P1 and P2 and NMOS transistors N1 and N2.

The PMOS transistor P1 has a source connected to a power source via a parasitic unit LC1 and a gate to which an input signal VIN is input. The NMOS transistor N1 has a source connected to the ground via a parasitic unit LC2, a gate to which the input signal VIN is input and a drain through which an output signal VOUT is output.

The PMOS transistor P2 has a source connected to a drain of the PMOS transistor P1, a gate connected to the ground via the parasitic unit LC2 and a drain through which the output signal VOUT is output.

The input signal VIN gradually changes from a low level to a high level, and from a high level to a low level.

In the above input circuit, the source of the NMOS transistor N1 and the gate of the PMOS transistor P2 are connected in common to the ground via the parasitic unit LC2. Therefore, only in the case where the potential of the input signal VIN gradually changes from the low level to the high level, the input circuit provides the effect that the output signal VOUT does not oscillate even if ground distortion occurs.

FIG. 14 shows an input circuit according to a fourth embodiment of the present invention.

The input circuit comprises a CMOS inverter including PMOS transistors P1 and P2 and NMOS transistors N1 and N2.

The PMOS transistor P1 has a source connected to a power source via a parasitic unit LC1, a gate to which an input signal VIN is input and a drain through which an output signal VOUT is output. The NMOS transistor N1 has a source connected to the ground via a parasitic unit LC2 and a gate to which the input signal VIN is input.

The NMOS transistor N2 has a source connected to a drain of the NMOS transistor N1, a gate connected to the ground via the parasitic unit LC1 and a drain through which the output signal VOUT is output.

The input signal VIN gradually changes from a low level to a high level, and from a high level to a low level.

In the above input circuit, the source of the PMOS transistor P1 and the gate of the NMOS transistor N2 are connected in common to the power source through the parasitic unit LC1. Therefore, only in the case where the potential of the input signal VIN gradually changes from the high level to the low level, the input circuit provides the effect that the output signal VOUT does not oscillate even if ground distortion occurs.

As has been described above, with the input circuit of the present invention, even when the driving force of an NMOS transistor (or a PMOS transistor), constituting the input circuit, is reduced, the driving force of a PMOS transistor (or an NMOS transistor) is also reduced.

Accordingly, the threshold value of the input circuit can be prevented from changing, even if the ground potential or the source potential is distorted. In addition, if the input signal is gradually changed in level around the threshold value of the input circuit, the output signal is prevented from oscillating.

For example, in the conventional input circuit, the threshold value is changed to Vthc + VOLP/2 and the output signal is oscillated, when ground distortion occurs. In contrast, with the input circuit of the present invention, under the conditions of VOLP > (VCC/2)-|VthP| and VN > VIN-VthN, even when ground distortion occurs, the threshold value is a constant determined by the formula VP + VthN-|VthP| and the output signal does not oscillate.

## Claims

1. An input circuit comprising:
   a first MOS transistor (P1) of a first conductivity type having a source connected to a first potential supplying source and a gate to which an input signal (VIN) is input;
   a second MOS transistor (N1) of a second conductivity type having a source connected to a second potential supplying source and a gate to which the input signal (VIN) is input;
   a third MOS transistor (P2) of the first conductivity type having a source connected to a drain of the first MOS transistor (P1), a gate connected to the second potential supplying source and a drain through which an output signal (VOUT) is output; and
   a fourth MOS transistor (N2) of the second conductivity type having a source connected to a drain of the second MOS transistor (N1), a gate connected to the first potential supplying source and a drain through which the output signal (VOUT) is output.

2. The input circuit according to claim 1, characterized in that the source of the first MOS transistor (P1) and the gate of the fourth MOS transistor (N2) are connected to a first node (A) of a power source line; and the source of the second MOS transistor (N1) and the gate of the third MOS transistor (P2) are connected to a first node (B) of a grounded line.

3. The input circuit according to claim 1, characterized in that the source of the first MOS transistor (P1) and the gate of the fourth MOS transistor (N2) are connected to the first potential supplying source via a first parasitic capacitance and parasitic reactance (LC1); and the source of the second MOS transistor (N1) and the gate of the third MOS transistor (P2) are connected in common to the second potential supplying source via a second parasitic capacitance and parasitic reactance (LC2).

4. An input circuit comprising:
   a first MOS transistor (P1) of a first conductivity type having a source connected to a first potential supplying source and a gate to which an input signal (VIN) is input;
   a second MOS transistor (N1) of a second conductivity type having a source connected to a second potential supplying source, a gate to which the input signal (VIN) is input and a drain through which an output signal (VOUT) is output;
   a third MOS transistor (P2) of the first conductivity type having a source connected to a drain of the first MOS transistor (P1), a gate connected to the second potential supplying source and a drain through which the output signal (VOUT) is output.

5. The input circuit according to claim 4, characterized in that the source of the second MOS transistor (N1) and the gate of the third MOS transistor (P2) are connected to a first node (B) of a grounded line.

6. The input circuit according to claim 4, characterized in that the source of the second MOS transistor (N1) and the gate of the third MOS transistor (P2) are connected in common to the second potential supplying source via a parasitic capacitance and parasitic reactance (LC2).

7. An input circuit comprising:
   a first MOS transistor (P1) of a first conductivity type having a source connected to a first potential supplying source, a gate to which an input signal (VIN) is input and a drain through which an output signal (VOUT) is output;
   a second MOS transistor (N1) of a second conductivity type having a source connected to a second potential supplying source and a gate to which the input signal (VIN) is input; and
   a third MOS transistor (N2) of the second conductivity type having a source connected to a drain of the second MOS transistor (N1), a gate connected to the first potential supplying source and a drain through which the output signal (VOUT) is output.

8. The input circuit according to claim 7, characterized in that the source of the first MOS transistor (P1) and the gate of the third MOS transistor (N2) are connected to a first node (A) of a power source line.

9. The input circuit according to claim 7, characterized in that the source of the first MOS transistor (P1) and the gate of the third MOS transistor (N2) are connected to the first potential supplying source via a capacitance and parasitic reactance (LC1).

F I G. 1

F I G. 2

F I G. 4

F I G. 3

FIG. 5

FIG. 7

FIG. 6

FIG. 8

FIG. 9

$V_{IN}$

Vthc

Vthc $(\frac{1}{2}$Vcc$)$

$V_{IN}$

$V_{OUT}$

Vcc

0V

$V_b$

VOLP

0V

FIG. 10

$V_{IN}$

Vthc

Vthc $(\frac{1}{2}$Vcc$)$

$V_{IN}$

$V_{OUT}$

Vcc

0V

$V_a$

Vcc

VOLP

F I G. 11

F I G. 12

F I G. 13

F I G. 14